# EUROPÄISCHE PATENTSCHRIFT

(11) **EP 2 250 509 B1**
(45) Veröffentlichungstag und Bekanntmachung des Hinweises auf die Patenterteilung: **08.04.2015**
(21) Anmeldenummer: 09718554.0
(22) Anmeldetag: 27.02.2009
(51) Int. Cl.: G01R 15/20, H05K 1/14, H05K 7/14

(54) **STROMMESSVORRICHTUNG MITTELS MAGNETEMPFINDLICHEM SENSOR FÜR EIN LEISTUNGSELEKTRONISCHES SYSTEM**
CURRENT MEASURING DEVICE USING A MAGNETICALLY SENSITIVE SENSOR FOR A POWER ELECTRONICS SYSTEM
DISPOSITIF DE MESURE DU COURANT AU MOYEN D'UN CAPTEUR MAGNÉTOSENSIBLE POUR UN SYSTÈME ÉLECTRONIQUE DE PUISSANCE

(30) Priorität: 05.03.2008 DE 102008012665
(43) Veröffentlichungstag der Anmeldung: 17.11.2010
(73) Patentinhaber: Conti Temic Microelectronic GmbH, 90411 Nürnberg (DE)
(72) Erfinder: KRELLA, Uwe, 90443 Nürnberg (DE); MATTHES, Katrin, 90480 Nürnberg (DE); HIEMER, Gerhard, 90478 Nürnberg (DE)
(74) Vertreter: Bonn, Roman Klemens
(86) Internationale Anmeldenummer: PCT/DE2009/000272
(87) Internationale Veröffentlichungsnummer: WO 2009/109168

(56) Entgegenhaltungen:
- US-A- 6 166 464
- US-A1- 2006 052 914
- US-A1- 2008 048 642

## Beschreibung

Die Erfindung betrifft eine Strommessvorrichtung in leistungselektronischen Systemen. Leistungselektronische Systeme, bei denen eine Strommessung erforderlich sein kann, sind beispielsweise Pulswechselrichter, Bordnetzwandler und Batterieüberwachungseinrichtungen.

DE 102006006314 A1 zeigt eine Vorrichtung zur Strommessung, die in eine Steckerverbindung integriert ist. Zur Stromerfassung wird mindestens ein Hall-Sensor in einer Schlitzung eines elektrischen Leiters der Steckerverbindung angeordnet. Die Steckerverbindung umfasst einen Powerpin, der über eine Phasenisolierbuchse auf einer Leiterplatte angeordnet ist. In der Phasenisolierbuchse ist mindestens ein Ringkern konzentrisch um den elektrischen Leiter angeordnet.

Die für diese Vorrichtung vorgesehenen Steckerverbindungen werden nicht in allen leistungselektronischen Systemen mit Stromerfassung benötigt, sie führen aber zu einem erhöhten Bedarf an Bauraum. Zudem verursachen sie Kosten.

US 2006/0052914 offenbart ein leistungselektronisches System mit einer Strommessvorrichtung gemäß dem Oberbegriff des Anspruchs 1.

Aufgabe der vorliegenden Erfindung ist die Minimierung des Bauraumbedarfs für leistungselektronische Systeme mit Stromerfassung, die insbesondere im Automobilbau eingesetzt werden. Zudem sollen Kosten minimiert werden.

Die Aufgabe wird durch eine Vorrichtung mit den Merkmalen des Anspruchs 1 gelöst. Vorteilhafte Weiterbildungen der Erfindung ergeben sich aus den Unteransprüchen, wobei auch Kombinationen und Weiterbildungen einzelner Merkmale miteinander denkbar sind.

Die Halbleiterbauelemente eines leistungselektronischen Systems sind auf einer Leiterplatte angeordnet. In der Praxis kommt hierbei vorzugsweise eine Direct-bonded-copper (DBC)-Keramiksubstrat-Technologie zum Einsatz.

Ein Rahmen, vorzugsweise aus glasfaserverstärktem Kunststoff, der die Leiterplatte umläuft, wird auch als Bondrahmen bezeichnet, wenn er zur Befestigung von Bonddrähten dient, die mit der Leiterplatte verbunden werden. Dieser Rahmen dient vorzugsweise der Befestigung der Stromschienen der Lastleitungen und gegebenenfalls der Steuerleitungen und deren mechanische Anbindung an die Leiterplatte.

Die Stromschienen können über Bonddrähte elektrisch mit den DBC-Modulen verbunden werden.

Vorteilhafterweise werden die magnetischen Feldlinien, die sich beim Fließen von Strom längs eines elektrischen Leiters ausbilden, durch einen annähernd ringförmigen weichmagnetischen Kern konzentriert.

Der weichmagnetische Kern umgibt die Isolierung des elektrischen Leiters und ist im Rahmen angeordnet. An einer Stelle ist der rechteckförmige weichmagnetische Kern unterbrochen, hier befindet sich eine Aussparung. In dieser Aussparung ist ein magnetempfindlicher Sensor, vorzugsweise ein Hall-Sensor, angeordnet. Die in einem Hall-Sensor induzierte elektrische Spannung ist proportional zur Stärke des Magnetfelds, welches durch den im Leiter fließenden Strom induziert wird. Das Magnetfeld kann mit einem beliebigen magnetempfindlichen Sensor gemessen werden. In der Praxis bietet ein Hall-Sensor den Vorteil, dass er einfach anzuordnen ist, indem er in die Aussparung des weichmagnetischen Kerns von außen auf den Mittelpunkt des Leiters weisend hineinragt.

Der Vorteil einer solchen Anordnung des weichmagnetischen Kerns der Strommessvorrichtung im Rahmen und des magnetempfindlichen Sensors in der Aussparung des weichmagnetischen Kerns liegt im Sparen von Bauraum, wodurch insgesamt eine höhere Packungsdichte der leistungselektronischen Komponenten erzielt werden kann. Es entfallen Steckverbindungen und zusätzliche Leitungen, die bei einer externen Anordnung der gesamten Strommessvorrichtung notwendig wären. Die Montage der Strommessvorrichtung ist stark vereinfacht. Hierdurch werden Kosten minimiert und gleichzeitig die Zuverlässigkeit erhöht.

Bei leistungselektronischen Systemen, die Halbleiter-Schaltelemente wie z. B. Insulated Gate Bipolar Transistoren (IGBT) umfassen, z. B. bei einem Pulswechselrichter, werden diese Schalter über eine separate elektronische Schaltung angesteuert, die sich vorzugsweise auf einer zweiten Leiterplatte befindet. In einer vorteilhaften Ausführungsform ist diese Leiterplatte am Rahmen befestigt, verläuft parallel zur Ebene der Leiterplatte, auf der die Leistungsbauelemente angeordnet sind, und umfasst eine Auswerteelektronik für den magnetempfindlichen Sensor. Durch diese Anordnung wird viel Bauraum gespart, Leitungen und Steckverbindungen entfallen, was zu niedrigeren Kosten führt.

Zum Abführen der Wärme aus den Leistungsbauelementen kann die Leiterplatte auf einen Kühlkörper gelötet werden. Da der weichmagnetische Kern, der die Isolierung des elektrischen Leiters umgibt, im Rahmen angeordnet ist, ist er über diesen thermisch an die gekühlte Leiterplatte gekoppelt. Da der magnetempfindliche Sensor in der Aussparung des weichmagnetischen Kerns angeordnet ist, profitiert er ebenfalls von der thermischen Kopplung an den Kühlkörper. Dadurch ist eine bessere thermische Anbindung der Strommessvorrichtung an das Kühlwasser gewährleistet, wodurch sich das thermische Verhalten der Strommessung verbessert.

Zur Herstellung eines leistungselektronischen Systems mit integrierter Strommessvorrichtung können der magnetempfindliche Sensor und der die Isolierung des elektrischen Leiters umgebende weichmagnetische Kern während des Spritzgießverfahrens zur Erstellung des die Leiterplatte umlaufenden Rahmens aus glasfaserverstärktem Kunststoff im Rahmen fixiert werden. Der magnetempfindliche Sensor wird auf diese Weise in der Aussparung des die Isolierung des elektrischen Leiters umgebenden weichmagnetischen Kerns angeordnet.

Dieses Verfahren ermöglicht eine weitere Verdichtung des bestehenden Bauraumes. Für die Umspritzung mit glasfaserverstärktem Kunststoff ist kein weiterer Prozess-Schritt notwendig. Dieser erfolgt bereits, um die Stromschienen und Befestigungselemente zu befestigen. Die vollständige Umspritzung des weichmagnetischen Kerns und des magnetempfindlichen Sensors mit glasfaserverstärktem Kunststoff bewirkt eine hohe Vibrationsfestigkeit der Strommessvorrichtung.

Zur Herstellung eines leistungselektronischen Systems, bei dem eine zweite Leiterplatte die Ansteuerelektronik der Leistungsschalter und die Auswerteelektronik der Strommessvorrichtung umfasst, kann der weichmagnetische Kern während des Spritzgießverfahrens zur Erstellung des die Leiterplatte umlaufenden Rahmens im Rahmen fixiert und die Aussparung des weichmagnetischen Kerns freigehalten werden. Der magnetempfindliche Sensor wird mechanisch auf der Leiterplatte für die Ansteuerelektronik befestigt. Beim Befestigen der Leiterplatte für die Ansteuerelektronik am Rahmen kommt der magnetempfindliche Sensor in der Aussparung weichmagnetischen Kerns zu liegen. Dieses Verfahren ermöglicht die hohe Bauraumverdichtung durch Einsparen einer externen Leiterplatte, Leitungen und Steckerverbindungen und zeigt ebenfalls verbesserte Vibrationsfestigkeit aufgrund der vollständigen Umspritzung des weichmagnetischen Kerns mit glasfaserverstärktem Kunststoff.

Im Folgenden werden Ausführungsbeispiele der Erfindung anhand von Zeichnungen näher erläutert.
Fig. 1 zeigt einen Querschnitt durch die Strommessvorrichtung eines leistungselektronischen Systems.
Fig. 2 zeigt als Beispiel für ein leistungselektronisches System mit Strommessvorrichtung einen Dreiphasen-Pulswechselrichter.

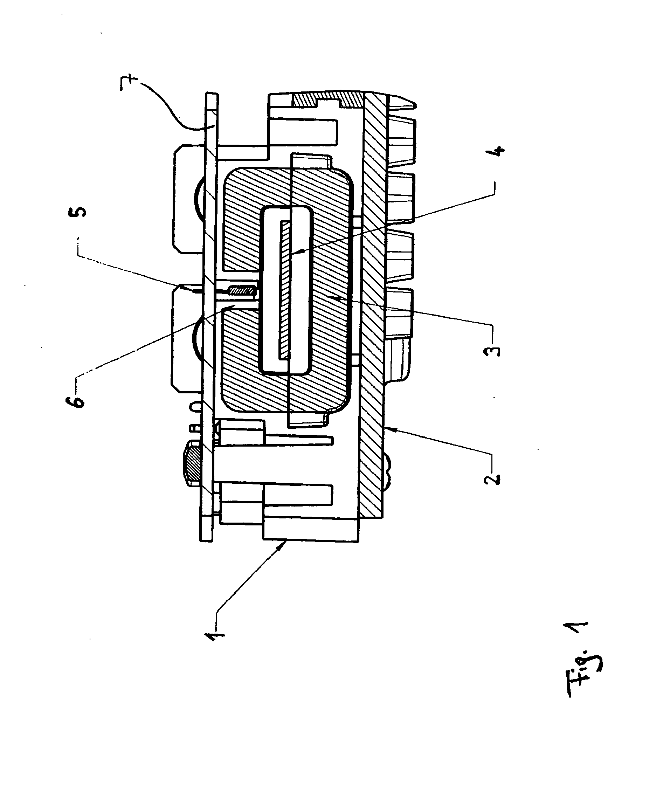

Im Querschnitt nach Fig. 1 ist ein elektrischen Leiter (4) dargestellt, der senkrecht zur Schnittebene verläuft. Der Strom, der durch den Leiter (4) fließt, wird von der Messvorrichtung gemessen. Dazu umfasst die Messvorrichtung einen weichmagnetischen Kern (3), der im Rahmen (1) angeordnet ist. "Im Rahmen (1)" meint hierbei, dass der weichmagnetische Kern (3) entsprechend einem nachfolgend beschriebenen Verfahren im Bereich des Rahmens (1) vollständig mit Kunststoff umspritzt wird.

Der Rahmen (1) umläuft die Leiterplatte, auf der die leistungselektronischen Bauelemente schaltungstechnisch angeordnet sind. Der elektrische Leiter (4) ist durch den Rahmen (1) geführt.

Fig. 1 zeigt gemäß einer bevorzugten Ausführungsform der Strommessvorrichtung den die Isolierung des elektrischen Leiters (4) umgebenden weichmagnetischen Kern (3), der an einer Stelle (6) geöffnet ist. Ein magnetempfindlicher Sensor (5), vorzugsweise ein Hall-Sensor, ist in der Aussparung (6) des die Isolierung des elektrischen Leiters (4) umgebenden weichmagnetischen Kerns (3) angeordnet.

Wie beispielhaft in Fig. 1 gezeigt wird, kann der magnetempfindliche Sensor (5) auf einer zweiten Leiterplatte (7) fixiert sein, die am Rahmen (1) befestigt ist.

Der weichmagnetische Kern (3) kann über den die Leiterplatte umlaufenden Rahmen (1) und damit über die Leiterplatte thermisch an einen Kühlkörper (2) gekoppelt sein, indem der Kühlkörper an die Leiterplatte gelötet ist. Auch der in der Aussparung (6) des weichmagnetischen Kerns (3) angeordnete magnetempfindliche Sensor (5) wird von einer indirekten Kühlung durch den Kühlkörper (2) profitieren.

In dem in Fig. 1 gezeigten Ausführungsbeispiel ist eine zweite Leiterplatte (7) vorhanden, die am Rahmen (1) befestigt ist und auf der die Elektronik zur Ansteuerung des leistungselektronischen Systems, des magnetempfindlichen Sensors (5) sowie eine Auswerteelektronik für den magnetempfindlichen Sensor angeordnet ist.

Ein Verfahren, wie ein solches System hergestellt werden kann, wird im Folgenden beschrieben:
Der Rahmen (1), der in diesem Ausführungsbeispiel die Aufgabe eines Bondrahmens erfüllt, wird in einem Spritzgießverfahren hergestellt, bei dem eine glasfaserverstärkte Kunststoffschmelze in die gewünschte Form gegossen wird. Die Elemente, die innerhalb des Rahmens (1) liegen sollen, werden hierbei von der glasfaserverstärkten Kunststoffschmelze umspritzt. Zu diesen Elementen zählt bei dem in Fig. 1 gezeigten Ausführungsbeispiel der elektrische Leiter (4) und der weichmagnetische Kern (3) der Strommessvorrichtung. Die Aussparung (6) des die Isolierung des elektrischen Leiters (4) umgebenden weichmagnetischen Kerns (3) wird während des Spritzgießens freigehalten.
Der magnetempfindliche Sensor (5) wird mechanisch auf der Leiterplatte für die Ansteuerelektronik (7) befestigt und kommt beim späteren Befestigen dieser Leiterplatte (7) am Rahmen (1) in der Aussparung (6) des weichmagnetischen Kerns (3) zu liegen.

Ein leistungselektronisches System ohne zweite Leiterplatte für die Ansteuerelektronik (7), kann entsprechend dem im Folgenden beschriebenen Verfahren hergestellt werden: Zusätzlich zum elektrischen Leiter (4) und dem weichmagnetischen Kern (3) der Strommessvorrichtung wird hierbei auch der magnetempfindliche Sensor (5) bereits während des Spritzgießverfahrens zur Erstellung des Rahmens (1) im Bereich des Rahmens umspritzt. Der magnetempfindliche Sensor (5) wird hierzu bereits vor dem Umspritzen in der Aussparung (6) des weichmagnetischen Kerns (3) positioniert.

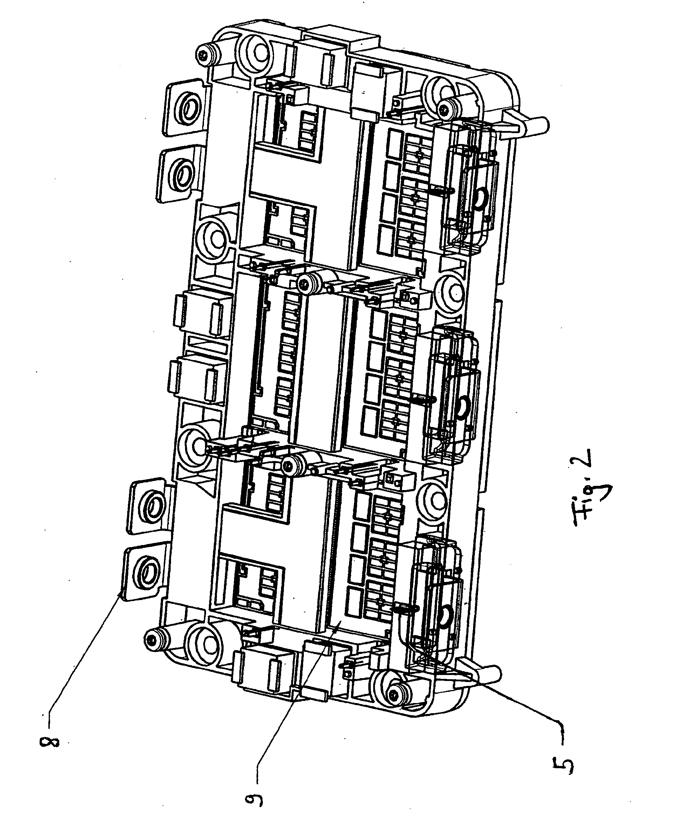

Fig. 2 zeigt die Leiterplatte (9), auf der die Halbleiterbauelemente eines leistungselektronischen Systems angeordnet sind. Das in diesem Ausführungsbeispiel gezeigte System ist ein Dreiphasen-Pulswechselrichter mit einer Strommessvorrichtung für jede Phase. Der Phasenstrom wird hierbei über einen elektrischen Leiter. Im gezeigten Ausführungsbeispiel sind die drei Phasenströme auf Stromschienen an der unteren Längsseite des Moduls durch den Rahmen geleitet.

Bei der Leiterplatte (9) kommt in diesem Ausführungsbeispiel eine Direct-bonded-copper (DBC)-Keramiksubstrat-Technologie zum Einsatz.

Der Rahmen erfüllt in dieser Ausführungsform die Funktion des Bondrahmens, da er zur Befestigung von Bonddrähten dient, die mit der Leiterplatte (9) verbunden werden. Der Rahmen dient zudem der Befestigung der Stromschienen (8) der Lastleitungen und gegebenenfalls der Steuerleitungen und deren mechanische Anbindung an die Leiterplatte (9).

Die Stromschienen (8) können über Bonddrähte elektrisch mit der Leiterplatte und/oder den darauf montierten Halbleiterbauelementen verbunden werden.

Fig. 2 zeigt deutlich, dass durch die Anordnung des magnetischen Kerns im Rahmen und des magnetempfindlichen Sensors (5) in der Aussparung des magnetischen Kerns keinerlei zusätzlicher Bauraum benötigt wird. Die Mess- und Versorgungsanschlüsse für den magnetempfindlichen Sensor (5) sind in diesem Ausführungsbeispiel auf der unteren Längsseite des Moduls nach oben herausgeführt.

### Bezugszeichenliste

- 1: Rahmen
- 2: Kühlkörper
- 3: Weichmagnetischer Kern
- 4: Elektrischer Leiter
- 5: Magnetempfindlicher Sensor
- 6: Aussparung
- 7: Leiterplatte für Ansteuerelektronik
- 8: Stromschiene
- 9: Leiterplatte

## Patentansprüche

1. Leistungselektronisches System mit einer Strommessvorrichtung umfassend:
o mindestens eine Leiterplatte (9),
o einen elektrischen Leiter (4) mit einer Isolierung, der durch einen die Leiterplatte (9) umlaufenden Rahmen (1) geführt ist,
o einen die Isolierung des elektrischen Leiters (4) umgebenden, im Rahmen (1) angeordneten, weichmagnetischen Kern (3) mit einer an einer Stelle am Kern (3) geöffneten Aussparung (6),
o einen magnetempfindlichen Sensor (5), insbesondere einen Hallsensor, der in der Aussparung (6) des die Isolierung des elektrischen Leiters (4) umgebenden weichmagnetischen Kerns (3) angeordnet ist,
**dadurch gekennzeichnet, dass**
o der elektrische Leiter (4) und der weichmagnetische Kern (3) von dem Rahmen (1) umspritzt sind.

2. Leistungselektronisches System nach Anspruch 1, wobei der elektrische Leiter (4) und der weichmagnetische Kern (3) von der glasfaserverstärkten Kunststoffschmelze umspritzt sind, wobei die glasfaserverstärkte Kunststoffschmelze in die gewünschte Form des Rahmens (1) gegossen ist.

3. Verfahren zur Herstellung eines leistungselektronischen Systems nach Anspruch 1, **gekennzeichnet durch folgende Verfahrensschritte:**
a. Umgeben eines elektrischen Leiters (4) mit einem weichmagnetischen Kern (3),
b. Vorsehen einer geöffneten Aussparung (6) an einer Stelle am weichmagnetischen Kern (3),
c. Umspritzen des elektrischen Leiters (4) und des weichmagnetischen Kerns (3) von einem Rahmen (1) in einem Spritzgießverfahren.

4. Verfahren nach Anspruch 3, wobei der elektrische Leiter (4) und der weichmagnetische Kern (3) von der glasfaserverstärkten Kunststoffschmelze umspritzt werden, wobei die glasfaserverstärkte Kunststoffschmelze in die gewünschte Form des Rahmens (1) gegossen wird.

5. Verfahren nach Anspruch 3 oder 4, wobei ein magnetempfindlicher Sensor (5) vor dem Umspritzen des Rahmens (1) in der Aussparung (6) des weichmagnetischen Kerns (3) positioniert und zusätzlich zum elektrischen Leiter und dem weichmagnetischen Kern im Bereich des Rahmens umspritzt wird.

## Claims

1. Power electronics system with a current measuring device comprising:
o at least one circuit board (9),
o an electrical conductor (4) with an insulation, which is led through a frame (1) enclosing the circuit board (9),
o a soft-magnetic core (3) surrounding the insulation of the electrical conductor (4), arranged in the frame (1) and having a clearance (6), which is provided as an opening at one location of the core (3),
o a magnetically sensitive sensor (5), in particular a Hall sensor, which is arranged in the clearance (6) in the soft-magnetic core (3) surrounding the insulation of the electrical conductor (4),
**characterized in that**
o the electrical conductor (4) and the soft-magnetic core (3) are overmoulded by the frame (1).

2. Power electronics system according to Claim 1, the electrical conductor (4) and the soft-magnetic core (3) being overmoulded by the glass-fibre-reinforced polymer melt, the glass-fibre-reinforced polymer melt being moulded into the desired form of the frame (1).

3. Method for producing a power electronics system according to Claim 1, **characterized by** the following method steps:
a. surrounding an electrical conductor (4) with a soft-magnetic core (3),
b. providing an open clearance (6) at a location on the soft-magnetic core (3),
c. overmoulding the electrical conductor (4) and the soft-magnetic core (3) by a frame (1) in an injection-moulding process.

4. Method according to Claim 3, **wherein** the electrical conductor (4) and the soft-magnetic core (3) are overmoulded by the glass-fibre-reinforced polymer melt, the glass-fibre-reinforced polymer melt being moulded into the desired form of the frame (1).

5. Method according to Claim 3 or 4, **wherein,** before the overmoulding of the frame (1), a magnetically sensitive sensor (5) is positioned in the clearance (6) in the soft-magnetic core (3) and is overmoulded in the region of the frame in addition to the electrical conductor and the soft-magnetic core.

## Revendications

1. Système électronique de puissance ayant un dispositif de mesure du courant comprenant :
- au moins un circuit imprimé (9),
- un conducteur électrique (4) ayant une isolation, qui passe au travers d'un cadre (1) s'étendant autour du circuit imprimé (9),
- un noyau magnétique doux (3) entourant l'isolation du conducteur électrique (4), agencé dans le cadre (1) et présentant un évidement (6) ouvert à un endroit du noyau (3),
- un capteur à sensibilité magnétique (5), en particulier un capteur à effet Hall, qui est agencé dans l'évidement (6) du noyau magnétique doux (3) entourant l'isolation du conducteur électrique (4),
**caractérisé en ce que**
- le conducteur électrique (4) et le noyau magnétique doux (3) sont enrobés par le cadre (1).

2. Système électronique de puissance selon la revendication 1, dans lequel le conducteur électrique (4) et le noyau magnétique doux (3) sont enrobés par une matière plastique fondue renforcée par fibres de verre, étant entendu que la matière plastique fondue renforcée par fibres de verre est coulée dans la forme souhaitée du cadre (1).

3. Procédé de fabrication d'un système électronique de puissance selon la revendication 1, **caractérisé par** les étapes de procédé suivantes :
a. enveloppage d'un conducteur électrique (4) avec un noyau magnétique doux (3),
b. réalisation d'un évidement (6) ouvert à un endroit du noyau magnétique doux (3),
c. enrobage du conducteur électrique (4) et du noyau magnétique doux (3) par un cadre (1) dans un procédé de moulage par injection.

4. Procédé selon la revendication 3, dans lequel le conducteur électrique (4) et le noyau magnétique doux (3) sont enrobés par la matière plastique fondue renforcée par fibres de verre, étant entendu que la matière plastique fondue renforcée par fibres de verre est coulée dans la forme souhaitée du cadre (1).

5. Procédé selon les revendications 3 ou 4, dans lequel avant l'injection du cadre (1), un capteur à sensibilité magnétique (5) est installé dans l'évidement (6) du noyau magnétique doux (3) et est enrobé, en plus du conducteur électrique et du noyau magnétique doux, au niveau du cadre.
